# FASCICULE DE BREVET EUROPEEN

(11) **EP 3 171 417 B1**
(45) Date de publication et mention de la délivrance du brevet: **25.12.2019**
(21) Numéro de dépôt: 16198261.6
(22) Date de dépôt: 10.11.2016
(51) Int. Cl.: H01L 45/00

(54) **COMPOSANT ELECTRONIQUE ACTIONNABLE ELECTRO-CHIMIQUEMENT ET PROCEDE DE REALISATION DU COMPOSANT ELECTRONIQUE ACTIONNABLE**
ELEKTROCHEMISCH ZU BETÄTIGENDE ELEKTRONISCHE KOMPONENTE, UND VERFAHREN ZU HERSTELLUNG DIESER ELEKTRONISCHEN KOMPONENTE
ELECTRO-CHEMICALLY OPERABLE ELECTRONIC COMPONENT AND METHOD FOR PRODUCING THE OPERABLE ELECTRONIC COMPONENT

(30) Priorité: 17.11.2015 FR 1561019
(43) Date de publication de la demande: 24.05.2017
(73) Titulaire: COMMISSARIAT À L'ÉNERGIE ATOMIQUE ET AUX ÉNERGIES ALTERNATIVES, 75015 Paris (FR)
(72) Inventeur: OUKASSI, Sami, 38120 SAINT-EGREVE (FR); SALOT, Raphaël, 38250 LANS-EN-VERCORS (FR)
(74) Mandataire: Esselin, Sophie

(56) Documents cités:
- EP-A1- 3 151 294
- FR-A1- 3 002 695
- US-A1- 2006 093 872

## Description

Le domaine de l'invention est celui des composants accordables, et plus particulièrement les composants accordables à actionnement électrochimique.

Un composant accordable est un composant qui peut présenter, à la demande, plusieurs niveaux d'une réponse donnée. La variation de la réponse est ajustée par l'application d'un champ électrique. De manière générale, la variation de la réponse est liée à une modification de propriétés physico-chimiques d'au moins un matériau au sein de structure du composant. La variation peut ainsi être envisagée pour plusieurs types de réponses, par exemple une variation de conductivité électronique, de constante diélectrique, de conductivité thermique, d'indices optiques ou de grandeurs mécaniques.

L'actionnement électrochimique est un cas particulier : la variation de réponse du composant est liée à un changement de propriété(s) d'un matériau suite à une réaction électrochimique, obtenue par application d'un champ électrique.

L'actionnement électrochimique présente plusieurs avantages en comparaison aux autres modes d'actionnement (électrostatique, thermique, piézo-électrique etc...) :
- une très basse consommation d'énergie ;
- une faible tension d'actionnement ;
- une très grande précision d'ajustement, correspondant à une variation théorique des réactions électrochimiques à l'échelle du nanomètre.

Les composants accordables à actionnement électrochimique peuvent êtes classés en deux catégories, en fonction du mécanisme de la réaction électrochimique en jeu.

### Première catégorie : l'actionnement électrochimique par insertion d'ions dans un matériau d'électrode :

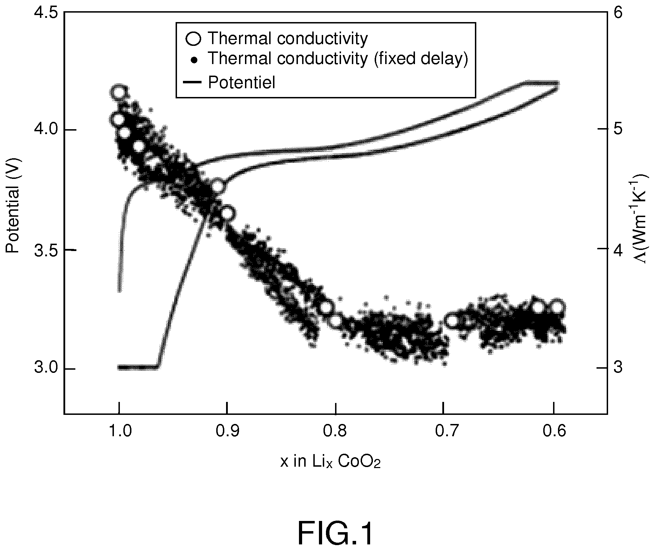

Dans ce cas l'insertion d'un ion au sein d'une structure hôte d'un matériau induit un changement de propriétés dudit matériau et implique une variation de la réponse du composant associé. Un exemple de ce type de mécanisme est rapporté dans le document Nature communications 5:4035-2014 et est illustré en figure 1, qui décrit une variation de la conductivité thermique (en l'occurrence la propriété variable) d'un matériau de composition LiₓCoO₂ au cours de l'insertion des ions Li⁺.

Il est à noter que d'une manière générale, l'insertion d'ions est le mécanisme qui induit le changement de propriétés du matériau. L'insertion d'ions peut avoir lieu par des mécanismes d'intercalation (dans des sites interstitiels de la structure hôte), d'alliage, ou encore de conversion.

### Deuxième catégorie : l'actionnement électrochimique par formation de filament à travers un conducteur ionique :

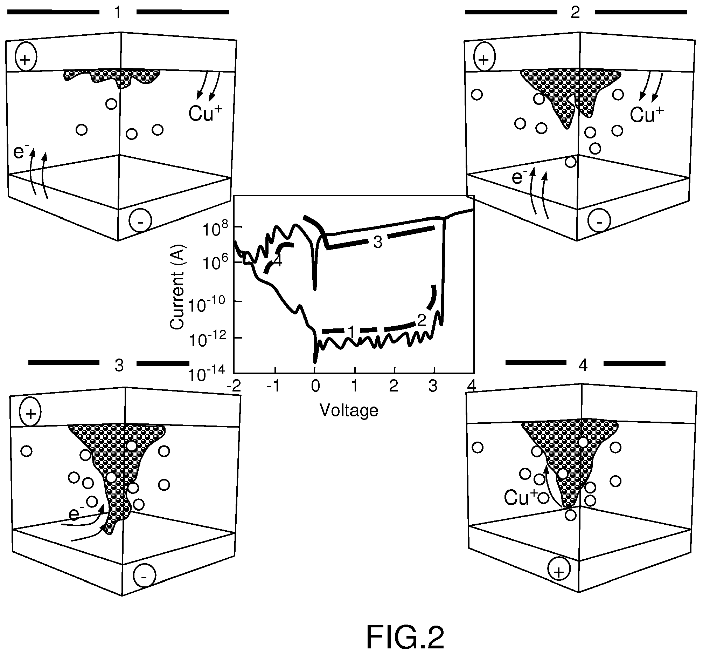

Dans ce cas la formation d'un filament par dissolution d'ions à travers un conducteur ionique induit un changement de propriétés de l'ensemble (conducteur ionique + filament, par comparaison à conducteur ionique seul). Un exemple de ce type de mécanisme est rapporté dans le document Nano Letters 14-2401-2014 et est illustré en figure 2, qui décrit une variation de la conductivité électronique entre les deux électrodes d'un système métal/Al₂O₃/métal par formation et retrait d'un filament métallique issu d'ions Cu⁺ (respectivement pour un état conducteur et un état isolant). Il est à noter que dans ce cas les électrodes d'actionnement et de mesures sont les mêmes.

Il apparait clairement qu'il est ainsi possible de moduler un nombre important de propriétés physico-chimiques de matériaux, et proposer différentes architectures de composants par actionnement électrochimique selon le premier ou le deuxième des modes décrits précédemment.

Chacun des modes d'actionnement présente un certain nombre d'avantages et de limitations qui sont détaillés dans la suite de la présente description.

Il a déjà été décrit dans la littérature brevet différentes approches de composants accordables avec actionnement électrochimique.

### Concernant l'actionnement électrochimique par insertion d'ions dans un matériau d'électrode :

La demande de brevet US20100003600 décrit un composant électronique à résistance variable mettant en œuvre la variation de la conductivité électronique d'un matériau suite à l'insertion/désinsertion d'ions Li⁺. L'insertion est mise en oeuvre par l'existence d'un empilement collecteur/électrode positive/électrolyte/électrode négative/collecteur déposé sur un substrat, et la variation de la résistance est mesurée au niveau d'électrodes interdigitées coplanaires traversant l'électrode d'insertion.

La demande de brevet US20100075181 décrit un composant électronique à capacité variable, utilisant le gain et la perte volumique d'un matériau au cours de réactions d'insertion/désinsertion. Le changement volumique induit une variation de distance entre deux plaques métalliques et par conséquent une variation de la capacité mesurée aux bornes des deux plaques considérées. L'insertion est assurée par la présence d'une structure de type collecteur de courant/électrode positive/électrolyte/électrode négative/collecteur déposé sur un substrat.

Le brevet US7262899 décrit un composant à réponse optique variable (structure de type guide d'onde). Dans ce cas une structure de type collecteur de courant / électrode positive /électrolyte / électrode négative / collecteur est présente avec un collecteur de courant supérieur composé de plusieurs lignes espacées d'une distance donnée. La structure précédente permet d'insérer de manière contrôlée les ions lithium dans une des deux électrodes et modifier son indice de réfraction. La modification des indices entraine par conséquent une variation de la propagation de certaines longueurs d'ondes et permet de moduler le filtrage du composant.

Le brevet US7652907 décrit un composant électronique à réponse variable utilisé comme mémoire de stockage d'information. Le composant est une source de tension variable présentant une structure de type collecteur de courant/électrode positive/électrolyte/électrode négative/collecteur. La structure forme une batterie qui est caractérisée par un profil de tension au cours de l'insertion/désinsertion des ions dans les électrodes ; le profil dans le cadre de ce document est constitué de plusieurs plateaux, chaque valeur de tension d'un plateau correspond à un codage de l'information de la mémoire, par exemple 0 ou 1.

### Concernant l'actionnement électrochimique par formation de filament à travers un conducteur ionique :

La demande de brevet WO2014/025434 décrit un composant électronique, en l'occurrence un nœud mémoire de stockage de type résistif ou pont conducteur (CBRAM pour contact bridge random access memory).

Le composant électronique est caractérisé par une résistance variable en fonction de la présence ou pas de filament conducteur à travers un conducteur ionique (TaOₓ) placé entre deux contacts métalliques (Pd/Pd, voir page 4 du document PDF)

Le brevet EP2605274 décrit un composant à conductivité thermique variable. Il est décrit plus spécifiquement un circuit intégré associé à un système d'évacuation de chaleur composé de plusieurs ponts thermiques. Chaque pont thermique est relié à une zone du circuit intégré à travers un interrupteur thermique composé d'un tri-couche métal/conducteur ionique/métal.

La formation d'un filament conducteur à travers le conducteur ionique permet le passage d'un mode isolant à conducteur (thermique) et permettre de moduler l'évacuation de la chaleur induite par le fonctionnement du circuit intégré.

Le brevet US8410469 décrit un interrupteur radiofréquence (RF switch). La formation d'un filament à travers un conducteur ionique par l'application d'un champ électrique continu entre deux électrodes permet au composant de passer d'un état ON à un état OFF et d'assurer la conduction d'un signal radiofréquence.

Les deux modes d'actionnement électrochimique influencent de manière significative les performances des composants accordables dans lesquels ils sont mis en œuvre. Le Tableau 1 ci-après résume les différences majeures au niveau des avantages et des limitations. (Respectivement marqués en (+) et (-)).

**Tableau 1 : Comparaison des performances de composants accordables par rapport au mode d'actionnement mis en œuvre.**

| | *Actionnement électrochimique par insertion* | *actionnement électrochimique par formation de filament* |
|---|---|---|
| **Géométrie** | 2D/3D (+) | 1D (-) |
| **Rapport de modulation** | Moyen (-) | Élevé (+) |
| **États intermédiaires** | Oui (+) | Non (-) |
| **Temps de réponse** | >100 µs (-) | <1µs (+) |
| **Tension d'actionnement** | faible (1-2V) (+) | faible (1-2V) (+) |
| **Consommation d'énergie** | faible (0,1-1µJ) (+) | faible (0.1-1µJ) (+) |

Les deux modes d'actionnement sont caractérisés par une faible tension d'actionnement ainsi qu'une très faible consommation en énergie, ce qui est inhérent à l'actionnement électrochimique de manière générale.

Au niveau de la géométrie du composant, l'actionnement électrochimique par insertion se distingue par l'avantage de présenter une variation planaire ou volumique de l'état (2D) alors que l'actionnement filaire est par construction unidimensionnel.

Cet aspect est important dans la mesure où la géométrie peut limiter les possibilités de construction de composants : par exemple, il n'est pas possible de former un filament de diamètre couvrant une grande surface (quelques dizaines ou centaines de µm²), ni une longueur importante (une centaine de microns), ce qui limite le dimensionnement d'un composant dans les proportions citées.

Au niveau du rapport de modulation (rapport entre les états extrêmes atteignables de la grandeur variable), l'avantage est à l'actionnement par formation de filament. En effet, la modulation de la réponse d'un composant est dans ce cas liée aux propriétés intrinsèques de deux matériaux totalement différents, en l'occurrence le conducteur ionique (par exemple isolant électronique, isolant thermique, transmission optique d'une longueur d'onde donnée) et le filament formé (respectivement conducteur électronique, conducteur thermique, absorption optique d'une longueur d'onde donnée) (d'autres propriétés peuvent être considérées, celles-ci sont données à titre d'exemple).

Dans le cas de l'actionnement par insertion, la modulation est plus faible dans la mesure où la variation est réalisée par changement de propriétés d'un même matériau en passant d'un état inséré à un état désinséré.

Un actionnement électrochimique par insertion permet de disposer de plusieurs états intermédiaires d'une réponse donnée, qui correspond à un taux d'insertion donné de l'ion dans la structure du matériau hôte.

Le composant associé est ainsi accordable avec plusieurs niveaux de réponses possibles dans une plage donnée.

A l'inverse, un composant à actionnement électrochimique par formation de filament présente uniquement deux états ON et OFF.

Le temps de réponse est plus court dans le cas d'un composant à actionnement électrochimique par formation de filament. En effet, dans ce cas seule la mobilité d'ions au sein du conducteur ionique est présente et constitue l'étape limitante dans la cinétique de réaction.

Dans le cas de l'insertion, la diffusion d'ions au sein des deux électrodes positive et négative vient s'ajouter à la mobilité dans le conducteur ionique, et de ce fait la cinétique est plus lente.

On peut encore citer dans la littérature, le Document US 2006/093872 qui décrit un système correspondant à une batterie comportant deux électrodes (une positive et une négative) et une troisième électrode auxiliaire qui sert à protéger le système en cas de surtension. Le principe consiste à connecter une des deux électrodes (+ ou -) à l'auxiliaire pour faire migrer des ions vers l'auxiliaire (ou inversement), les ions sont insérés et non électrodéposés, les deux électrodes de mesure et d'actionnement étant dépendantes.

Pour la réalisation des électrodes, il est par ailleurs enseigné dans la demande de brevet FR 3 002 695, un procédé de fabrication d'une batterie monolithique avec des modes de fabrication des électrodes de stockage et d'actionnement. Il est aussi fait référence au brevet EP3151294 qui décrit un dispositif de mémoire résistive (voir figure 11).

Dans ce contexte, la présente invention concerne un nouveau mode d'actionnement électrochimique permettant d'avoir les avantages des deux modes de l'art antérieur sans les limitations associées.

Le principe de la présente invention consiste à réaliser un composant accordable par un nouveau mode d'actionnement électrochimique, basé sur la réalisation d'un électrodépôt de couche métallique. La couche d'électrodépôt est formée par migration (sous l'action d'un champ électrique) des ions du métal considéré depuis une électrode de stockage vers un collecteur de courant, à travers un conducteur ionique. Une illustration de ce phénomène est décrite dans le document J. Electrochem. Soc.-2000- -517-23. La variation de la réponse du composant est obtenue par la formation d'un électrodépôt et son retrait entre deux électrodes séparées initialement par un conducteur ionique.

Plus précisément la présente invention a pour objet un composant électronique actionnable électro-chimiquement selon l'objet de la revendication indépendante de dispositif 1.

Le conducteur ionique peut être en contact avec l'électrode de stockage et avec ladite première électrode d'actionnement.

L'électrode de stockage peut être en contact avec la deuxième électrode d'actionnement.

La caractéristique peut par exemple être une conductivité électronique, une permittivité, une conductivité thermique, un indice optique etc...

Avantageusement, les ions sont des ions métalliques.

La première électrode d'actionnement peut être en au moins un matériau ne pouvant former un composé avec lesdits ions.

Ainsi selon la présente invention, on réalise une opération d'électrodépôt au niveau de la première électrode d'actionnement et non une insertion des ions dans ladite électrode, sous l'action d'une opération d'actionnement via une tension ou un courant appliqué entre les deux électrodes d'actionnement et ce en raison de la nature même de ladite électrode d'actionnement.

Selon des variantes de l'invention, le composant électronique accordable comprend en outre une électrode saturable d'insertion pour lesdits ions, en contact avec ladite première électrode d'actionnement. Au-delà d'une certaine quantité d'ions insérés dans ladite électrode, on réalise également une opération d'électrodépôt au niveau de ladite première électrode d'actionnement associée à ladite électrode saturable d'insertion et non plus l'insertion des ions dans ladite électrode, sous l'action d'une opération d'actionnement via une tension ou un courant appliqué entre les deux électrodes d'actionnement et ce en raison de la saturation en ions de ladite électrode saturable d'insertion desdits ions.

Selon des variantes de l'invention, les électrodes d'actionnement sont positionnées l'une par rapport à l'autre parallèlement au substrat de manière à assurer la formation d'un électrodépôt dans un plan orthogonal audit substrat, les électrodes de mesure étant positionnées l'une par rapport à l'autre orthogonalement au substrat.

Selon des variantes de l'invention, les électrodes d'actionnement sont positionnées l'une par rapport à l'autre orthogonalement au substrat de manière à assurer la formation d'un électrodépôt dans un plan parallèle audit substrat, les électrodes de mesure étant positionnées l'une par rapport à l'autre parallèlement au substrat.

Selon des variantes de l'invention, le composant électronique accordable comprend en outre au moins une troisième électrode de mesure et une quatrième électrode de mesure séparées par ladite électrode de stockage, de manière à moduler l'insertion et la désertion d'ions au niveau de ladite électrode de stockage et mesurer une modification d'au moins une caractéristique de l'électrode de stockage.

La caractéristique pouvant ainsi être mesurée peut être la même que celle mesurée entre les première et deuxième électrodes de mesure ou être une caractéristique différente.

Selon des variantes de l'invention, l'électrode de stockage est en métal, les ions métalliques étant libérés par ladite électrode de stockage en cours de fonctionnement.

L'électrode de stockage peut-être constituée d'un métal, permettant de libérer des ions métalliques sous l'action des électrodes d'actionnement.

Selon des variantes de l'invention, le composant électronique accordable comprend en outre un premier diélectrique de passivation interne et/ou un second diélectrique de passivation externe pouvant être en SiO₂ ou Si₃N₄ ou Al₂O₃.

Selon des variantes de l'invention, l'électrode de stockage est une électrode de stockage d'ions métalliques Li ou Ag ou Cu ou Na ou Mg ou Al ou Ca.

Selon des variantes de l'invention, l'électrode de stockage est en UCoO₂.

Selon des variantes de l'invention, l'électrode d'insertion en ions est en Si ou Ge ou Al, l'électrode de stockage comportant des ions Li.

Selon des variantes de l'invention, le conducteur ionique est un phosphate de lithium nitruré (LIPON).

Selon des variantes de l'invention, l'une ou les électrodes d'actionnement est(sont) en Cu ou Pt.

Selon des variantes de l'invention, l'une ou les électrodes de mesure est(sont) en Ni ou Cu ou Mo ou W ou Pt ou oxyde conducteur ITO (l'ITO peut fonctionner, néanmoins la diffusion d'ions (Li+ en particulier) est en partie non réversible, de ce fait le fonctionnement du composant peut ne pas être optimal).

L'exemple de l'invention a aussi pour objet un composant électronique, comportant sur un substrat plusieurs blocs élémentaires, chaque bloc élémentaire étant contrôlable de manière indépendante et comprenant :
- au moins une première et une deuxième électrodes d'actionnement ;
- au moins une première et une deuxième électrodes de mesure électriquement indépendantes des première et deuxième électrodes d'actionnement ;
- au moins une électrode de stockage configurée pour libérer des ions ;
- au moins un conducteur ionique conducteur desdits ions et situé dans une région disposée entre lesdites électrodes de mesure ;
- lesdites électrodes de mesure étant configurées pour mesurer au moins une caractéristique de ladite région disposée entre les première et deuxième électrodes de mesure,
ledit ensemble comprenant un dispositif adapté pour :
∘ appliquer à chaque bloc, une tension ou un courant entre les première et deuxième électrodes d'actionnement pour permettre soit la migration d'ions de l'électrode de stockage vers la première électrode d'actionnement formant sur celle-ci un dépôt électrochimique à travers le conducteur ionique soit la dissolution au moins partielle du dépôt électrochimique et
∘ pour mesurer sur chaque boc élémentaire, entre les première et deuxième électrodes de mesure une modification d'au moins une caractéristique de la région disposée entre les première et une deuxième électrodes de mesure, induite par la formation du dépôt électrochimique ou par la dissolution au moins partielle de celui-ci

L'invention a aussi pour objet un procédé de fabrication d'un composant selon l'invention comportant les étapes suivantes :
- le dépôt et la structuration d'au moins une électrode d'actionnement à la surface d'un substrat ;
- le dépôt et la structuration d'au moins une électrode de mesure à la surface dudit substrat ;
- le dépôt et la structuration d'une électrode de stockage ;
- le dépôt et la structuration d'un conducteur ionique ;
- le dépôt et la structuration d'un diélectrique de passivation interne.

Selon des variantes de l'invention, le dépôt de l'électrode de stockage est effectué par pulvérisation réactive d'une cible, la structuration pouvant être effectuée par photolithographie et gravure par plasma .

Selon des variantes de l'invention, le dépôt du conducteur ionique est effectué par pulvérisation réactive, la structuration pouvant être effectuée par photolithographie et gravure plasma.

L'invention sera mieux comprise et d'autres avantages apparaîtront à la lecture de la description qui va suivre donnée à titre non limitatif et grâce aux figures annexées parmi lesquelles :
- la figure 1 illustre la variation de la conductivité thermique d'un matériau LiₓCoO₂ en fonction du taux d'insertion en lithium x, selon l'art connu ;
- la figure 2 illustre la variation de la conductivité électronique par création de filament Cu à travers un conducteur ionique Cu selon l'art connu ;
- les figures 3a et 3b schématisent en coupe un premier exemple de composant de l'invention sans tension d'actionnement et en présence d'une tension d'actionnement ;
- Les figures 4a et 4b illustrent des vues de dessus d'un composant accordable selon l'invention, (respectivement pour le composant à l'état sans et avec électrodépôt dans la zone intermédiaire entre les électrodes de mesure) ;
- les figures 5a et 5b illustrent une variante de l'invention dans laquelle, le composant électronique accordable comporte en outre une électrode supplémentaire dite électrode d'insertion « saturable » en l'ion (respectivement pour le composant à l'état sans et avec électrodépôt dans la zone intermédiaire entre les électrodes de mesure) ;
- les figures 6a et 6b illustrent une variante de l'invention dans laquelle, le composant électronique accordable exploite une mise à profit de la variation possible liée à l'insertion/ désinsertion de l'électrode de stockage avec l'addition d'une paire d'électrodes séparées par l'électrode de stockage (respectivement pour le composant à l'état sans et avec électrodépôt dans la zone intermédiaire entre les électrodes de mesure) ;
- les figures 7a et 7b illustrent une variante de l'invention dans laquelle le composant électronique accordable présente une configuration permettant une formation de l'électrodépôt dans un plan parallèle au substrat (respectivement pour le composant à l'état sans et avec électrodépôt dans la zone intermédiaire entre les électrodes de mesure) ;
- les figures 8a et 8b illustrent un ensemble de fonctions électroniques accordables selon l'invention (respectivement pour le composant à l'état sans et avec électrodépôt dans la zone intermédiaire entre les électrodes de mesure).

De manière générale, la présente invention a pour objet un composant électronique accordable par un nouveau mode d'actionnement électrochimique, basé sur la réalisation d'un électrodépôt de couche métallique.

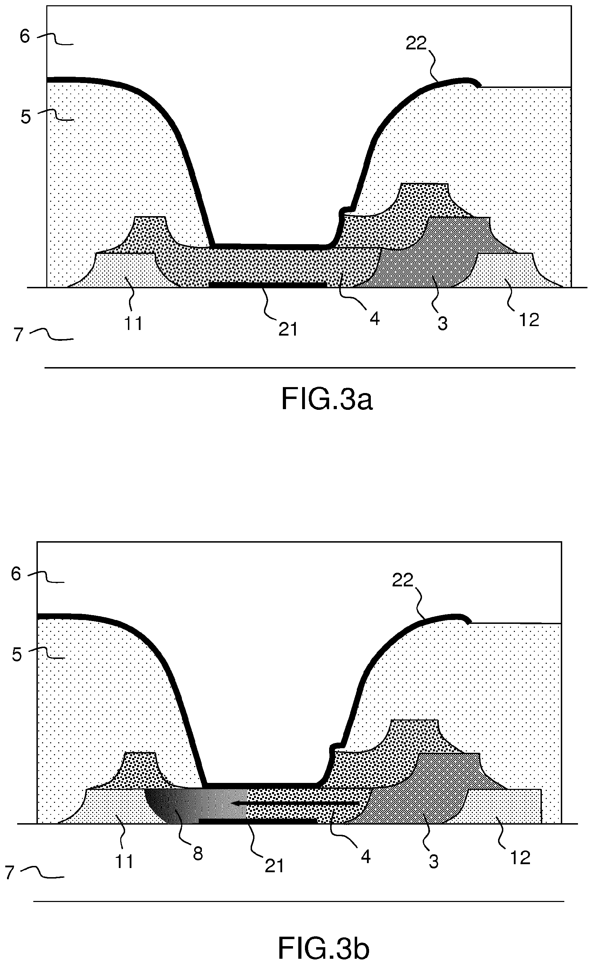

La figure 3a illustre le schéma en coupe d'un exemple d'architecture de composant selon l'invention. Le composant présente une première paire d'électrodes d'actionnement 11 et 12, une deuxième paire d'électrodes de mesure 21 et 22, une électrode de stockage d'ions 3, un conducteur ionique 4, et des couches de passivation 5 et 6, l'ensemble étant déposé sur un substrat 7.

Le principe de fonctionnement d'un tel composant accordable est explicité ci-après.

L'application d'une tension U_{actionnement} entre les électrodes 11 et 12 (électrodes d'actionnement) pendant une durée t_{actionnement} entraine la migration d'ions depuis l'électrode de stockage d'ions 3 à travers le conducteur ionique 4, les ions s'accumulent ensuite au niveau de la surface de l'électrode 11 sous forme de dépôt continu. La couche d'électrodépôt 8 est ainsi formée dans au moins une partie de la zone située entre les deux électrodes 21 et 22 (électrodes de mesure), comme montré sur figure 3b. La présence de l'électrodépôt induit une modification d'au moins une des caractéristiques de la zone entre les électrodes de mesure 21 et 22. Cette caractéristique peut être par exemple une conductivité électronique, une permittivité, une conductivité thermique, un indice optique etc...

La réponse du composant entre les deux électrodes de mesure 21 et 22 est ainsi modifiée par rapport à la modification de la caractéristique de la zone entre les électrodes de mesure 21 et 22, liée à la formation de l'électrodépôt. Les électrodes d'actionnement 11-12 et de mesure 21-22 sont distinctes, contrairement au cas de l'actionnement par formation de filament.

L'application d'une tension U'_{actionnement} entre les électrodes 11 et 12 entraine la migration d'ions dans le sens inverse que précédemment, i.e. depuis la zone d'électrodépôt à la surface de l'électrode 11 vers l'électrode de stockage et s'y insèrent de nouveau. Cette opération induit une variation de la réponse du composant dans le sens opposé à la variation induite par l'application de la tension U_{actionnement}.

Le composant accordable tel que décrit présente plusieurs états possibles de variation de sa réponse :
- un état sans électrodépôt entre les électrodes 21 et 22 : la réponse du composant est directement liée aux caractéristiques du conducteur ionique, seul présent dans la zone intermédiaire 21/22 ;
- un état avec électrodépôt total entre les électrodes 21 et 22 : cet état correspond à la migration de la totalité des ions présents initialement dans l'électrode de stockage 3 vers l'électrode 11 et la formation d'un électrodépôt à ce niveau ;
- des états avec électrodépôts intermédiaires : ces différents états correspondent à la migration d'une partie des ions présents initialement dans l'électrode de stockage 3 vers l'électrode 11 et la formation d'un électrodépôt à ce niveau.

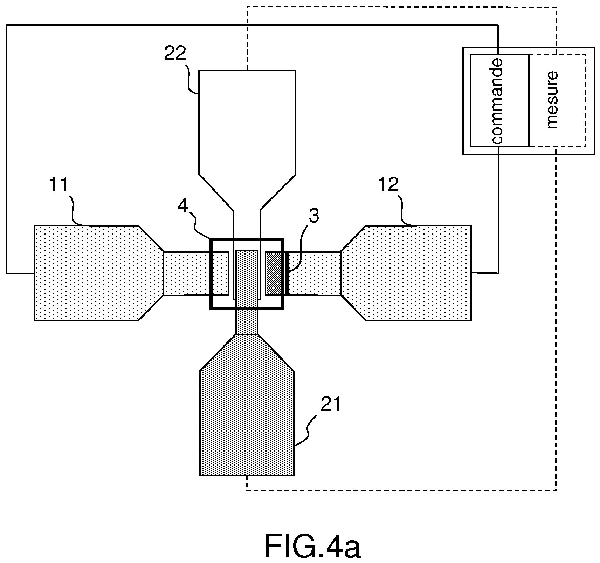

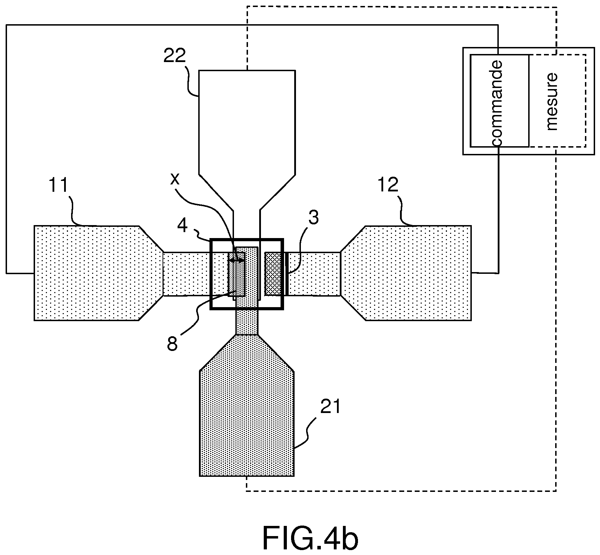

Les figures 4a et 4b illustrent des vues de dessus d'un composant accordable selon l'invention, (figure 4a et figure 4b : respectivement pour le composant à l'état sans et avec électrodépôt dans la zone intermédiaire 21/22). La figure 4b montre la présence de l'électrodépôt qui est caractérisé par une largeur notée x. Cette largeur x varie en fonction des conditions d'actionnement du composant, plus particulièrement cette largeur x est directement corrélée à la durée t_{actionnement} de l'application de tension U_{actionnement}. La variation de cette largeur x permet de changer les propriétés de la zone intermédiaire 21/22 et par conséquent d'obtenir des réponses intermédiaires (entre sans électrodépôt et avec électrodépôt total) du composant accordable. Il est à noter que la largeur x s'étend depuis le bord de l'électrode 11 jusqu'à une limite qui dépasse nécessairement le bord de l'électrode 22 (figure 4b), autrement dit l'épaisseur de l'électrodépôt (égale à la largeur x) est nécessairement supérieure à la distance entre les électrodes 11 et 21 sur la figure 4b.

Selon un mode particulier de fonctionnement, l'application d'un courant I_{actionnement} (au lieu de tension précédemment) entre les électrodes 11 et 12 pendant une durée t_{actionnement} est utilisée pour la migration des ions vers l'électrode 11 (formation de l'électrodépôt), et un courant l'_{actionnement} est appliqué pendant une durée t'_{actionnement} et est utilisé pour assurer la migration dans le sens opposé (ré-insertion dans l'électrode de stockage 3).

Selon un autre mode particulier de fonctionnement, l'application d'un courant I_{actionnement} entre les électrodes 11 et 12 pendant une durée t_{actionnement} est utilisée pour la migration des ions vers l'électrode 11 (formation de l'électrodépôt), et une tension U_{actionnement} est appliquée pendant une durée t'_{actionnement} et est utilisée pour assurer la migration dans le sens opposé (ré-insertion dans l'électrode de stockage 3).

Selon un autre mode particulier de fonctionnement, l'application d'une tension U_{actionnement} entre les électrodes 11 et 12 pendant une durée t_{actionnement} est utilisée pour la migration des ions vers l'électrode 11 (formation de l'électrodépôt), et un courant I_{actionnement} est appliqué pendant une durée t'_{actionnement} et est utilisé pour assurer la migration dans le sens opposé (ré-insertion dans l'électrode de stockage 3).

Les différents modes cités permettent de former l'électrodépôt de différentes manières pour répondre à des contraintes qui peuvent être différentes d'une application à l'autre. Par exemple l'utilisation d'un actionnement sous courant élevé permet de former l'électrodépôt dans un temps très court, alors que l'utilisation d'une tension permet de maitriser de manière précise l'épaisseur de l'électrodépôt formé.

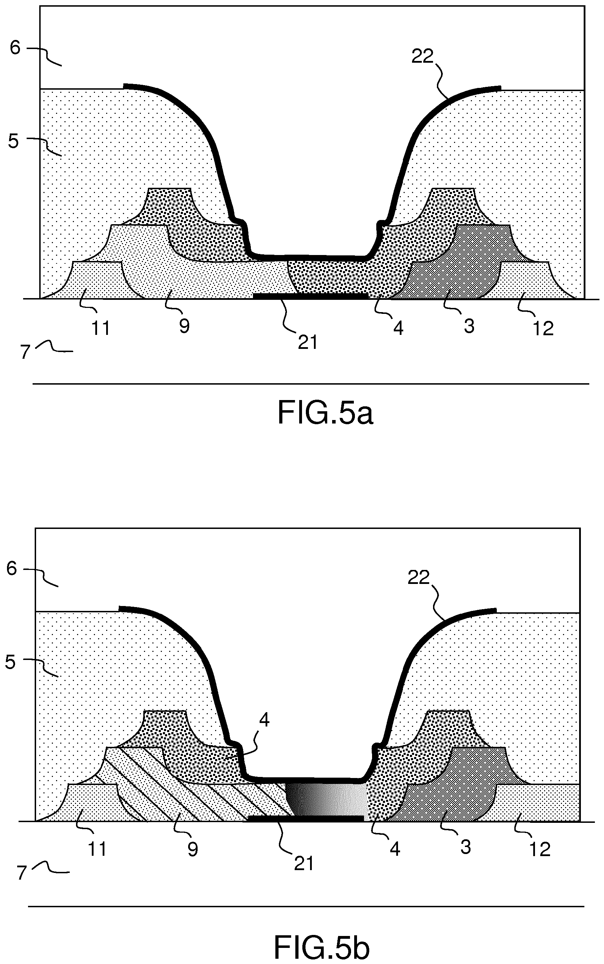

Selon une autre variante de l'invention illustrée en figures 5a et 5b, le composant électronique accordable comporte en outre une électrode supplémentaire 9 dite électrode d'insertion « saturable » en l'ion considéré, ce qui permet d'avoir davantage d'états intermédiaires. En effet, une électrode saturable (par exemple Si, Ge, ou Al dans le cas de l'ion Li⁺) est capable d'absorber une quantité d'ions jusqu'à saturation, point à partir duquel les ions arrivant vers l'électrode commencent à former une couche du métal de l'ion considéré et conduire à une phase d'électrodépôt. De cette façon, la réponse de la zone intermédiaire définie entre les électrodes 21/22 est influencée par les différents états d'insertion de la couche 9, et augmente le nombre d'états intermédiaires possibles du composant.

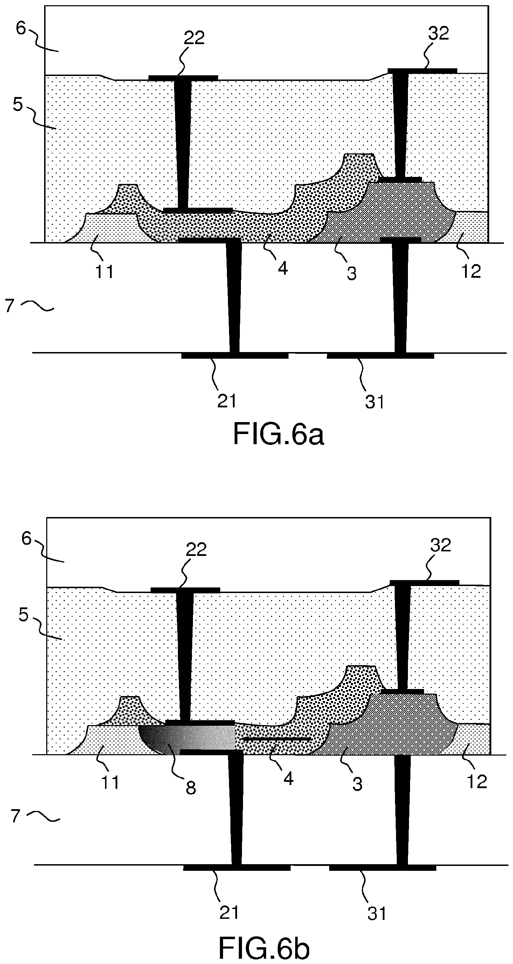

Selon une autre variante de l'invention illustrée en figures 6a et 6b, le composant électronique accordable exploite une mise à profit de la variation possible liée à l'insertion/désinsertion de l'électrode de stockage. Cette approche implique une addition d'une paire d'électrodes 31/32 séparées par l'électrode de stockage 3, et permettant au composant accordable de moduler sa réponse (la même que celle entre 21/22 ou une réponse différente) par le biais de cette architecture. Selon cette variante, les commandes des électrodes 21 et 31 sont reprises en face de dessous (sur les figures) par l'intermédiaire de via au travers du substrat 7.

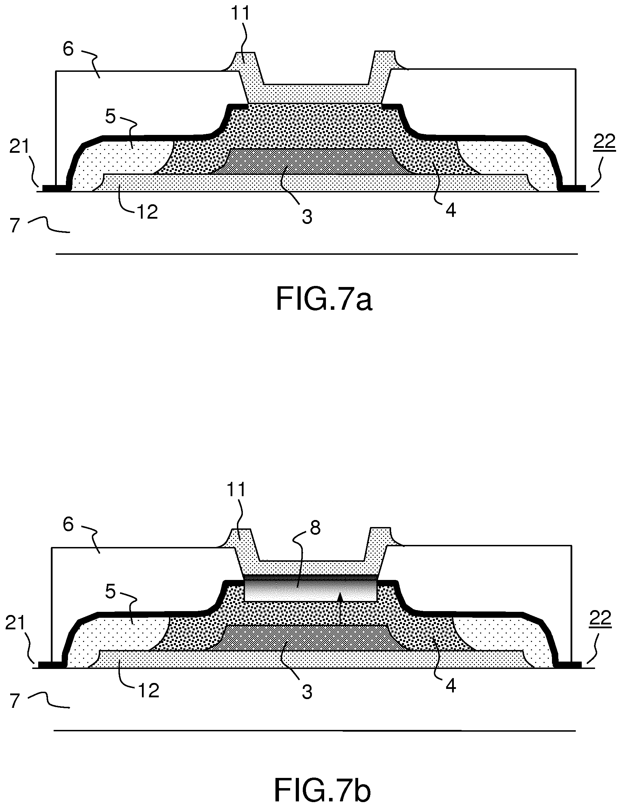

Selon une autre variante de l'invention illustrée en figures 7a et 7b, le composant électronique accordable, peut également présenter une configuration permettant une formation de l'électrodépôt dans un plan parallèle au substrat (dans les variantes de l'invention précédemment décrites, l'électrodépôt est formé dans un plan orthogonal au substrat). Les électrodes 12/3/11 sont disposées dans un plan parallèle au plan du substrat.

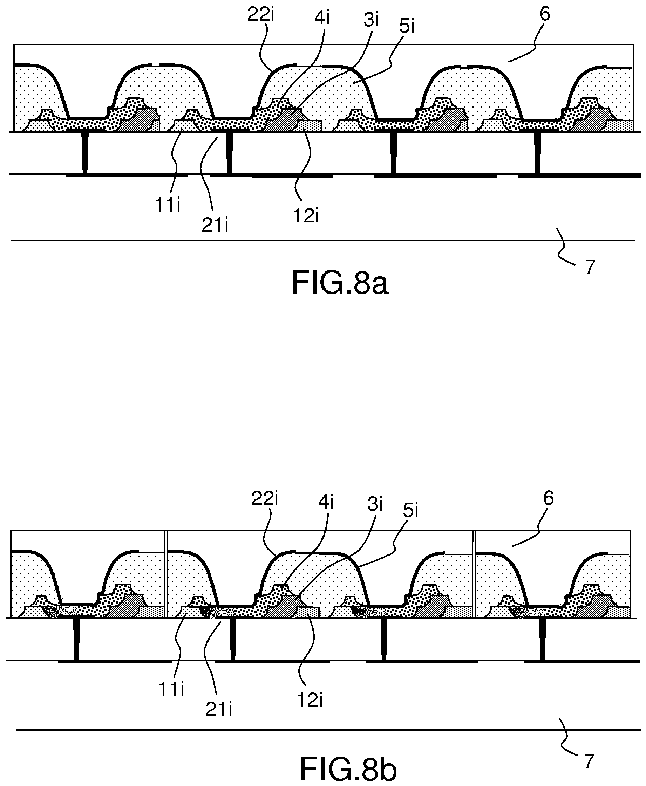

Avantageusement il est possible de réaliser selon la présente invention un ensemble de fonctions électroniques accordables sur un même substrat comme illustré en figure 8a et 8b et comprenant plusieurs types de blocs accordables selon l'architecture de l'invention, chaque bloc est contrôlable de manière indépendante. Tous les blocs peuvent être identiques, ou présenter certaines différences.

Sur un substrat commun 7, les différents blocs comprennent :
- une paire d'électrodes d'actionnement 11i/12i ;
- une paire d'électrodes de mesure 21i/22i ;
- une électrode de stockage 3i ;
- un conducteur ionique 4i ;
- un isolant interne 5i ;
un isolant externe commun 6 encapsulant l'ensemble des éléments précités.

Selon la présente invention, il est ainsi possible de réaliser la variation de plusieurs propriétés, par exemple: électronique (mémoires non-volatiles NVM, switchs, switch RF), thermique (switch thermique), optique (filtres, guides d'ondes), ferro/magnéto (capacité), etc...

### Exemple de procédé de réalisation d'un composant accordable selon l'invention :

### Etape 1 :

On procède au nettoyage d'un substrat, par exemple en silicium, ou en verre ou autre matériau semi-conducteur. Le nettoyage peut comprendre une étape de traitement thermique (200°C, 15min), suivi d'un traitement chimique de type RCA (par exemple à base de NH₄OH :H₂O₂ et de HCI : H₂O₂).

### Etape 2 :

On procède au dépôt et à la structuration des deux électrodes d'actionnement, par exemple en Cu ou en Pt de 0.25µm d'épaisseur. Une couche de Pt déposée par pulvérisation PVD peut être structurée par photolithographie et gravée par une solution chimique de type eau régale (mélange HCl+HNO₃).

### Etape 3 :

On procède au dépôt et à la structuration d'une électrode de mesure, par exemple en Ni, Cu, Mo, W, Pt ou oxyde conducteur transparent de composition ITO de 0.25µm d'épaisseur. Une couche de Pt déposée par pulvérisation PVD peut être structurée par photolithographie et gravée par une solution chimique de type eau régale (mélange HCl+HNO₃). La couche de la première électrode de mesure peut être obtenue simultanément avec celles d'électrodes d'actionnement si le matériau sélectionné est le même.

### Etape 4 :

On procède au dépôt et à la structuration d'une électrode de stockage d'ions, par exemple un oxyde de composition LiCoO₂ d'une épaisseur de 1µm (dans ce cas précis il s'agit de stockage d'ions lithium Li⁺). La couche LiCoO2 peut être obtenue par pulvérisation d'une cible de LiCoO2 sous Ar et peut être gravée par un plasma inductif sous Ar.

### Etape 5 :

On procède au dépôt et à la structuration d'un conducteur ionique, par exemple en LiPON (conduction ion Li⁺) d'une épaisseur de 1.5µm. la couche LiPON peut être déposée par pulvérisation réactive d'une cible Li₃PO₄ sous azote N₂, structurée par photolithographie et gravée par plasma inductif sous Ar.

### Etape 6 :

On procède au dépôt et à la structuration d'un diélectrique de passivation, par exemple en SiO₂, Si₃N₄, Al₂O₃, ou en polymère d'une épaisseur de 1µm. Par exemple une couche de Si₃N₄ peut être déposée par PECVD, structurée par photolithographie et gravée par un plasma inductif sous Ar.

### Etape 7 :

On procède au dépôt et à la structuration de la deuxième électrode de mesure, par exemple en Ni, Cu, Mo, W, Pt ou oxyde conducteur transparent de composition ITO de 0.25µm d'épaisseur. Une couche de Pt déposée par pulvérisation dépôt physique en phase vapeur « PVD », peut être structurée par photolithographie et gravée par une solution chimique de type eau régale (mélange HCl+HNO₃).

### Etape 8 :

On procède au dépôt et à la structuration d'un diélectrique de passivation, par exemple en SiO₂, Si₃N₄, Al₂O₃, ou en polymère d'une épaisseur de 2µm. Par exemple une couche de Si₃N₄ peut être déposée par dépôt chimique en phase vapeur assisté par plasma PECVD, structurée par photolithographie et gravée par un plasma inductif sous Ar.

Les avantages de la présente invention sont mis en exergue grâce au Tableau 2 ci-après et se situent notamment :
- au niveau de la géométrie: volumique (couche mince), continue et pouvant assurer un contact sur une grande surface et/ou hauteur ;
- au niveau du rapport de modulation: élevé dans la mesure où les deux états extrêmes sont liés à deux matériaux intrinsèquement différents (le conducteur ionique et l'électrodépôt) ;
- au niveau des états intermédiaires : états possibles, et correspondant à une certaine épaisseur de la couche d'électrodépôt formée, ladite épaisseur étant contrôlable théoriquement à l'échelle du nanomètre ;
- au niveau de temps de réponse: plus court que dans le cas d'un actionnement électrochimique par insertion, car la diffusion se fait uniquement au sein d'une seule électrode contrairement à des systèmes à deux électrodes.

**Tableau 2 : Comparaison des performances de composants accordables (art antérieur vs. invention) par rapport au mode d'actionnement mis en œuvre.**

| | *Actionnement électrochimique par insertion* | *actionnement électrochimique par formation de filament* | *Invention* |
|---|---|---|---|
| ***Géométrie*** | *2D*/*3D (*+*)* | *1D (*-*)* | *2D*/*3D (*+*)* |
| ***Rapport de modulation*** | *Moyen (*-*)* | *Élevé (*+*)* | *Élevé (*+*)* |
| ***États intermédiaires*** | *Oui (*+*)* | *Non (*-*)* | *Oui (*+*)* |
| ***Temps de réponse*** | >*100 µs (*-*)* | *<1µs (*+*)* | *1-100µs* |
| ***Tension d'actionnement*** | *faible (1-2V) (*+*)* | *faible (1-2V) (*+*)* | *faible (1-2V) (*+*)* |
| ***Consommation d'énergie*** | *faible (0,1-1µJ) (*+*)* | *faible (0,1-1µJ) (*+*)* | *faible (0,1-1µJ) (*+*)* |

Grâce à la présente invention, il est ainsi possible de concevoir des composants électroniques accordables pouvant être notamment de type résistance, ou de type capacitance ou de type inductance.

Ils peuvent également être de type microcommutateur électrique (switch), microcommutateur électrique radio-fréquence (RF switch), microcommutateur ou vanne thermique, mémoire non volatile, mémoire non volatile pour logique multi-valeurs (multiple valued logic memories).

## Revendications

1. Composant électronique actionnable électro-chimiquement comprenant :
- un substrat (7) ;
- au moins une première et une deuxième électrodes d'actionnement (11, 12) ;
- au moins une électrode de stockage configurée pour libérer des ions (3) sous l'action d'une tension d'actionnement ou d'un courant d'actionnement appliqué(e) auxdites électrodes d'actionnement, ladite électrode de stockage étant en contact direct avec ladite deuxième électrode d'actionnement.
**caractérisé en ce qu'**il comprend :
- au moins une première et une deuxième électrodes de mesure (21, 22) électriquement indépendantes des première et deuxième électrodes d'actionnement ;
- au moins un conducteur ionique (4) conducteur desdits ions et situé dans une région disposée entre lesdites électrodes de mesure;
- lesdites électrodes de mesure étant configurées pour mesurer au moins une caractéristique de ladite région disposée entre les première et deuxième électrodes de mesure ;
- un dispositif adapté pour :
∘ appliquer une tension ou un courant entre les première et deuxième électrodes d'actionnement pour permettre soit la migration d'ions de l'électrode de stockage vers la première électrode d'actionnement formant sur celle-ci un dépôt électrochimique à travers le conducteur ionique soit la dissolution au moins partielle du dépôt électrochimique et
∘ pour mesurer entre les première et deuxième électrodes de mesure une modification d'au moins une caractéristique de la région disposée entre les première et deuxième électrodes de mesure, induite par la formation du dépôt électrochimique ou par la dissolution au moins partielle de celui-ci, de manière à déterminer au moins une caractéristique dudit composant électronique.

2. Composant électronique selon la revendication 1, dans lequel le conducteur ionique est en contact avec l'électrode de stockage et avec ladite première électrode d'actionnement.

3. Composant électronique selon l'une des revendications 1 ou 2, dans lequel au moins ladite première électrode (11) d'actionnement est en un matériau ne pouvant former un composé avec lesdits ions.

4. Composant électronique selon l'une des revendications 1 à 3, comprenant en outre une électrode (9) saturable en insertion desdits ions en contact avec ledit conducteur ionique et en contact avec ladite première électrode d'actionnement.

5. Composant électronique selon l'une des revendications 1 à 4, dans lequel les électrodes d'actionnement sont positionnées l'une par rapport à l'autre parallèlement au substrat, les électrodes de mesure étant positionnées l'une par rapport à l'autre orthogonalement au substrat.

6. Composant électronique selon l'une des revendications 1 à 4, dans lequel les électrodes d'actionnement sont positionnées l'une par rapport à l'autre orthogonalement au substrat, les électrodes de mesure étant positionnées l'une par rapport à l'autre parallèlement au substrat.

7. Composant électronique selon l'une des revendications 1 à 6, comprenant en outre au moins une troisième électrode de mesure et une quatrième électrode (31, 32) de mesure séparées par ladite électrode de stockage de manière à moduler l'insertion et la désertion d'ions au niveau de ladite électrode de stockage et mesurer une modification d'au moins une caractéristique de l'électrode de stockage.

8. Composant électronique selon l'une des revendications 1 à 7, comprenant en outre un premier diélectrique de passivation interne et/ou un second diélectrique de passivation externe pouvant être en SiO₂ ou Si₃N₄ ou Al₂O₃.

9. Composant électronique selon l'une des revendications 1 à 8, dans lequel l'électrode de stockage est une électrode de stockage d'ions métalliques Li ou Ag ou Cu ou Na ou Mg ou Al ou Ca.

10. Composant électronique selon la revendication 9, dans lequel l'électrode de stockage est en LiCoO_{2.}

11. Composant électronique selon l'une des revendications 1 à 8, **caractérisé en ce que** l'électrode de stockage est constituée d'un métal, permettant de libérer des ions métalliques sous l'action des électrodes d'actionnement.

12. Composant électronique selon les revendications 4 et 9 ou 10, dans lequel l'électrode d'insertion en ions est en Si ou Ge ou Al, l'électrode de stockage comportant des ions Li.

13. Composant électronique selon l'une des revendications 1 à 12 dans lequel, le conducteur ionique est un phosphate de lithium nitruré (LIPON).

14. Composant électronique selon l'une des revendications 1 à 13, dans lequel l'une ou les électrodes d'actionnement est(sont) en Cu ou Pt.

15. Composant électronique selon l'une des revendications 1 à 14, dans lequel l'une ou les électrodes de mesure est(sont) en Ni ou Cu ou Mo ou W ou Pt ou oxyde conducteur ITO.

16. Procédé de fabrication d'un composant selon l'une des revendications 1 à 14, comportant les étapes suivantes :
- le dépôt et la structuration d'au moins une électrode d'actionnement à la surface d'un substrat ;
- le dépôt et la structuration d'au moins une électrode de mesure à la surface dudit substrat ;
- le dépôt et la structuration d'une électrode de stockage ;
- le dépôt et la structuration d'un conducteur ionique ;
- le dépôt et la structuration d'un diélectrique de passivation interne.

17. Procédé de fabrication d'un composant accordable selon la revendication 16, dans lequel le dépôt de l'électrode de stockage est effectué par pulvérisation réactive d'une cible, la structuration pouvant être effectuée par photolithographie et gravure par plasma .

18. Procédé de fabrication d'un composant accordable selon l'une des revendications 16 ou 17, dans lequel le dépôt du conducteur ionique est effectué par pulvérisation réactive, la structuration pouvant être effectuée par photolithographie et gravure plasma.

19. Composant électronique selon l'une des revendications 1 à 15 et comportant sur un substrat plusieurs blocs élémentaires, chaque bloc élémentaire étant contrôlable de manière indépendante et comprenant :
- au moins une première et une deuxième électrodes d'actionnement (11i, 12i) ;
- au moins une première et une deuxième électrodes de mesure (21i, 22i) électriquement indépendantes des premières et deuxième électrodes d'actionnement ;
- au moins une électrode de stockage configurée pour libérer des ions (3i) ;
- au moins un conducteur ionique (4i) conducteur desdits ions et situé dans une région disposée entre lesdites électrodes de mesure ;
- lesdites électrodes de mesure étant configurées pour mesurer au moins une caractéristique de ladite région disposée entre les première et deuxième électrodes de mesure ,
ledit composant comprenant un dispositif adapté pour :
∘ appliquer à chaque bloc, une tension ou un courant entre les première et deuxième électrodes d'actionnement pour permettre soit la migration d'ions de l'électrode de stockage vers la première électrode d'actionnement formant sur celle-ci un dépôt électrochimique à travers le conducteur ionique soit la dissolution au moins partielle du dépôt électrochimique et
pour mesurer sur chaque boc élémentaire, entre les première et deuxième électrodes de mesure une modification d'au moins une caractéristique de la région disposée entre les première et une deuxième électrodes de mesure, induite par la formation du dépôt électrochimique ou par la dissolution au moins partielle de celui-ci.

## Patentansprüche

1. Elektrochemisch zu betätigendes elektronisches Bauteil, Folgendes beinhaltend:
- ein Substrat (7);
- mindestens eine erste und eine zweite Betätigungselektrode (11, 12);
- mindestens eine Speicherelektrode, welche konfiguriert ist, um Ionen (3) unter Einwirkung einer Betätigungsspannung oder eines Betätigungsstroms freizusetzen, welche(r) an die Betätigungselektroden angelegt wird, wobei die Speicherelektrode in direktem Kontakt mit der zweiten Betätigungselektrode steht,
**dadurch gekennzeichnet, dass** es Folgendes beinhaltet:
- mindestens eine erste und eine zweite Messelektrode (21, 22), welche elektrisch unabhängig von der ersten und der zweiten Betätigungselektrode sind;
- mindestens einen Ionenleiter (4), welcher die Ionen leitet und in einem Bereich befindlich ist, welcher zwischen den Messelektroden angeordnet ist;
- wobei die Messelektroden konfiguriert sind, um mindestens ein Merkmal des zwischen der ersten und der zweiten Messelektrode befindlichen Bereichs zu messen;
- eine Vorrichtung, welche für folgende Schritte geeignet ist:
∘ Anlegen einer Spannung oder eines Stroms zwischen der ersten und der zweiten Betätigungselektrode, um entweder die Wanderung von Ionen von der Speicherelektrode zu der ersten Betätigungselektrode zu ermöglichen, wodurch an dieser eine elektrochemische Ablagerung durch den Ionenleiter gebildet wird, oder die zumindest teilweise Auflösung der elektrochemischen Ablagerung und
∘ zum Messen, zwischen der ersten und der zweiten Messelektrode, einer Änderung mindestens eines Merkmals des zwischen der ersten und der zweiten Messelektrode angeordneten Bereichs, welche durch die Bildung der elektrochemischen Ablagerung oder durch die zumindest teilweise Auflösung der Ablagerung induziert wird, um so mindestens ein Merkmal des elektronischen Bauteils zu bestimmen.

2. Elektronisches Bauteil nach Anspruch 1, bei welchem der Ionenleiter in Kontakt mit der Speicherelektrode und mit der ersten Betätigungselektrode steht.

3. Elektronisches Bauteil nach einem der Ansprüche 1 oder 2, bei welchem mindestens die erste Betätigungselektrode (11) aus einem Material besteht, welches mit den Ionen keine Verbindung bilden kann.

4. Elektronisches Bauteil nach einem der Ansprüche 1 bis 3, zudem beinhaltend eine durch Einleiten der in Kontakt mit dem Ionenleiter und in Kontakt mit der ersten Betätigungselektrode stehenden Ionen sättigbare Elektrode (9).

5. Elektronisches Bauteil nach einem der Ansprüche 1 bis 4, bei welchem die Betätigungselektroden zueinander parallel zum Substrat positioniert sind, wobei die Messelektroden zueinander rechtwinklig zum Substrat positioniert sind.

6. Elektronisches Bauteil nach einem der Ansprüche 1 bis 4, bei welchem die Betätigungselektroden zueinander rechtwinklig zum Substrat positioniert sind, wobei die Messelektroden zueinander parallel zum Substrat positioniert sind.

7. Elektronisches Bauteil nach einem der Ansprüche 1 bis 6, zudem beinhaltend mindestens eine dritte Messelektrode und eine vierte Messelektrode (31, 32), welche durch die Speicherelektrode getrennt sind, um das Einleiten und das Ausleiten von Ionen auf Höhe der Speicherelektrode zu modulieren und eine Änderung von mindestens einem Merkmal der Speicherelektrode zu messen.

8. Elektronisches Bauteil nach einem der Ansprüche 1 bis 7, zudem beinhaltend ein erstes internes Passivierungsdielektrikum und/oder ein zweites externes Passivierungsdielektrikum, welche(s) aus SiO₂ oder Si₃N₄ oder Al₂O₃ bestehen kann/können.

9. Elektronisches Bauteil nach einem der Ansprüche 1 bis 8, bei welchem die Speicherelektrode eine Elektrode zum Speichern metallischer Li- oder Ag- oder Cu- oder Na- oder Mg- oder Al- oder Ca-Ionen ist.

10. Elektronisches Bauteil nach Anspruch 9, bei welchem die Speicherelektrode aus LiCoO₂ besteht.

11. Elektronisches Bauteil nach einem der Ansprüche 1 bis 8, **dadurch gekennzeichnet, dass** die Speicherelektrode aus einem Metall besteht, welches es ermöglicht, metallische Ionen unter der Einwirkung der Betätigungselektroden freizusetzen.

12. Elektronisches Bauteil nach den Ansprüchen 4 und 9 oder 10, bei welchem die Ionen-Einleitungselektrode aus Si oder Ge oder Al besteht, wobei die Speicherelektrode Li-Ionen enthält.

13. Elektronisches Bauteil nach einem der Ansprüche 1 bis 12, bei welchem der Ionenleiter ein nitridiertes Lithiumphosphat (LIPON) ist.

14. Elektronisches Bauteil nach einem der Ansprüche 1 bis 13, bei welchem eine der oder die Betätigungselektroden aus Cu oder Pt besteht/bestehen.

15. Elektronisches Bauteil nach einem der Ansprüche 1 bis 14, bei welchem eine der oder die Messelektroden aus Ni oder Cu oder Mo oder W oder Pt oder leitfähigem Oxid ITO besteht/bestehen.

16. Verfahren zum Herstellen eines Bauteils nach einem der Ansprüche 1 bis 14, beinhaltend folgende Schritte:
- Ablagern und Strukturieren mindestens einer Betätigungselektrode an der Oberfläche eines Substrates;
- Ablagern und Strukturieren mindestens einer Messelektrode an der Oberfläche des Substrates;
- Ablagern und Strukturieren einer Speicherelektrode;
- Ablagern und Strukturieren eines Ionenleiters;
- Ablagern und Strukturieren eines internen Passivierungsdielektrikums;

17. Verfahren zum Herstellen eines Bauteils nach Anspruch 16, bei welchem das Ablagern der Speicherelektrode durch reaktives Zerstäuben eines Targets erfolgt, wobei das Strukturieren durch Fotolithografie und Plasmagravur erfolgen kann.

18. Verfahren zum Herstellen eines Bauteils nach einem der Ansprüche 16 oder 17, bei welchem das Ablagern des Ionenleiters durch reaktives Zerstäuben erfolgt, wobei das Strukturieren durch Fotolithografie und Plasmagravur erfolgen kann.

19. Elektronisches Bauteil nach einem der Ansprüche 1 bis 15 und welches an einem Substrat mehrere elementare Blöcke beinhaltet, wobei jeder elementare Block unabhängig steuerbar ist, und Folgendes beinhaltend:
- mindestens eine erste und eine zweite Betätigungselektrode (11i, 12i);
- mindestens eine erste und eine zweite Messelektrode (21i, 22i), welche elektrisch unabhängig von der ersten und der zweiten Betätigungselektrode sind;
- mindestens eine Speicherelektrode, welche zum Freisetzen von Ionen (3i) konfiguriert ist;
- mindestens einen Ionenleiter (4i), welcher die Ionen leitet und in einem Bereich befindlich ist, welcher zwischen den Messelektroden angeordnet ist;
- wobei die Messelektroden konfiguriert sind, um mindestens ein Merkmal des zwischen der ersten und der zweiten Messelektrode befindlichen Bereichs zu messen,
wobei das Bauteil eine Vorrichtung beinhaltet, welche für folgende Schritte geeignet ist:
∘ Anlegen an jeden Block einer Spannung oder eines Stroms zwischen der ersten und der zweiten Betätigungselektrode, um entweder die Wanderung von Ionen von der Speicherelektrode zu der ersten Betätigungselektrode zu ermöglichen, wodurch an dieser eine elektrochemische Ablagerung durch den Ionenleiter gebildet wird, oder die zumindest teilweise Auflösung der elektrochemischen Ablagerung und
∘ zum Messen, an jedem elementaren Block zwischen der ersten und der zweiten Messelektrode, einer Änderung mindestens eines Merkmals des zwischen der ersten und einer zweiten Messelektrode angeordneten Bereichs, welche durch die Bildung der elektrochemischen Ablagerung oder durch die zumindest teilweise Auflösung der Ablagerung induziert wird.

## Claims

1. Electrochemically actuatable electronic component comprising:
- a substrate (7);
- at least one first and one second actuating electrodes (11, 12);
- at least one storing electrode configured to free ions (3) under the action of an actuating voltage or an actuating current, applied on said actuating electrodes, said storing electrode being in direct contact with said second actuating electrode;
**characterized in that** it comprises:
- at least one first and one second measuring electrodes (21, 22), electrically independent from the first and second actuating electrodes;
- at least one ionic conductor (4) that is able to conduct said ions and that is located in a region placed between said measuring electrodes;
- said measuring electrodes being configured to measure at least one characteristic of said region placed between the first and second measuring electrodes;
- a device suitable for:
∘ applying a voltage or a current between the first and second actuating electrodes in order to allow either the migration of ions from the storing electrode to the first actuating electrode forming thereon an electrochemical deposition through the ionic conductor or the at least partial dissolution of the electrochemical deposition and
∘ for measuring, between the first and second measuring electrodes, a modification of at least one characteristic of the region placed between the first and second measuring electrodes, induced by the formation of the electrochemical deposition or by the at least partial dissolution thereof, so as to determine at least one characteristic of said electronic component.

2. Electronic component according to Claim 1, wherein the ionic conductor is making contact with the storing electrode and with said first actuating electrode.

3. Electronic component according to either one of Claims 1 or 2, wherein at least said first actuating electrode (11) is made of a material unable to form a compound with said ions.

4. Electronic component according to one of Claims 1 to 3, furthermore comprising an electrode (9) that is insertionally saturatable with said ions making contact with said ionic conductor and making contact with said first actuating electrode.

5. Electronic component according to one of Claims 1 to 4, wherein the actuating electrodes are positioned one with respect to the other parallelly to the substrate, the measuring electrodes being positioned one with respect to the other orthogonally to the substrate.

6. Electronic component according to one of Claims 1 to 4, wherein the actuating electrodes are positioned one with respect to the other orthogonally to the substrate, the measuring electrodes being positioned one with respect to the other parallelly to the substrate.

7. Electronic component according to one of Claims 1 to 6, furthermore comprising at least one third measuring electrode and one fourth measuring electrode (31, 32) that are separated by said storing electrode so as to modulate the insertion and deinsertion of ions into/from said storing electrode and to measure a modification of at least one characteristic of the storing electrode.

8. Electronic component according to one of Claims 1 to 7, furthermore comprising an internal first passivating dielectric and/or an external second passivating dielectric, possibly SiO₂ or Si₃N₄ or Al₂O₃.

9. Electronic component according to one of Claims 1 to 8, wherein the storing electrode is an electrode for storing Li or Ag or Cu or Na or Mg or Al or Ca metal ions.

10. Electronic component according to Claim 9, wherein the storing electrode is made of LiCoO₂.

11. Electronic component according to one of Claims 1 to 8, **characterized in that** the storing electrode consists of a metal allowing metal ions to be freed under the action of the actuating electrodes.

12. Electronic component according to Claims 4 and 9 or 10, wherein the electrode for inserting ions is made of Si or Ge or Al, the storing electrode including Li ions.

13. Electronic component according to one of Claims 1 to 12, wherein the ionic conductor is a lithium phosphorous nitride (LIPON).

14. Electronic component according to one of Claims 1 to 13, wherein one or the actuating electrodes is (are) made of Cu or Pt.

15. Electronic component according to one of Claims 1 to 14, wherein one or the measuring electrodes is (are) made of Ni or Cu or Mo or W or Pt or ITO conductive oxide.

16. Process for manufacturing a component according to one of Claims 1 to 14, including the following steps:
- depositing and structuring at least one actuating electrode on the surface of a substrate;
- depositing and structuring at least one measuring electrode on the surface of said substrate;
- depositing and structuring a storing electrode;
- depositing and structuring an ionic conductor;
- depositing and structuring an internal passivating dielectric.

17. Process for manufacturing a tuneable component according to Claim 16, wherein the storing electrode is deposited by reactive sputtering of a target, the structuring possibly being carried out by photolithography and plasma etching.

18. Process for manufacturing a tuneable component according to either one of Claims 16 or 17, wherein the ionic conductor is deposited by reactive sputtering, the structuring possibly being carried out by photolithography and plasma etching.

19. Electronic component according to one of Claims 1 to 15 and including on a substrate a plurality of elementary blocks, each elementary block being independently controllable and comprising:
- at least one first and one second actuating electrodes (11i, 12i);
- at least one first and one second measuring electrodes (21i, 22i) that are electrically independent from the first and second actuating electrodes;
- at least one storing electrode configured to free ions (3i);
- at least one ionic conductor (4i) that is able to conduct said ions and that is located in a region placed between said measuring electrodes;
- said measuring electrodes being configured to measure at least one characteristic of said region placed between the first and second measuring electrodes,
said component comprising a device suitable for:
∘ applying in each block, a voltage or a current between the first and second actuating electrodes in order to allow either the migration of ions from the storing electrode to the first actuating electrode forming thereon an electrochemical deposition through the ionic conductor or the at least partial dissolution of the electrochemical deposition and
∘ for measuring in each elementary block, between the first and second measuring electrodes, a modification of at least one characteristic of the region placed between the first and second measuring electrodes, induced by the formation of the electrochemical deposition or by the at least partial dissolution thereof.
